# EUROPÄISCHE PATENTSCHRIFT

(11) **EP 1 301 917 B1**
(45) Veröffentlichungstag und Bekanntmachung des Hinweises auf die Patenterteilung: **31.03.2010**
(21) Anmeldenummer: 01953789.3
(22) Anmeldetag: 13.06.2001
(51) Int. Cl.: G09F 9/33, G02B 3/00, H01L 25/075

(54) **PASSIVES STRAHLOPTIK-MODUL, INSBESONDERE ZUR VERWENDUNG MIT LEUCHTDIODEN**
PASSIVE RADIATION OPTICAL SYSTEM MODULE ESPECIALLY FOR USE WITH LIGHT-EMITTING DIODES
MODULE DE SYSTEME OPTIQUE DE RAYONNEMENT PASSIF, NOTAMMENT DESTINE A ETRE UTILISE AVEC DES DIODES ELECTROLUMINESCENTES

(30) Priorität: 18.07.2000 DE 10034886
(43) Veröffentlichungstag der Anmeldung: 16.04.2003
(73) Patentinhaber: OSRAM Opto Semiconductors GmbH, 93055 Regensburg (DE)
(72) Erfinder: BACHL, Bernhard, 14612 Falkensee (DE); BLÜMEL, Simon, 84069 Schierling (DE); KIRCHBERGER, Günter, 93161 Sinzing (DE); STOYAN, Harald, 93049 Regensburg (DE)
(74) Vertreter: Epping - Hermann - Fischer
(86) Internationale Anmeldenummer: PCT/DE2001/002191
(87) Internationale Veröffentlichungsnummer: WO 2002/007131

(56) Entgegenhaltungen:
- CH-A- 689 339
- DE-U- 9 307 862
- DE-U- 29 818 609
- DE-U- 29 822 207
- US-A- 5 660 461
- PATENT ABSTRACTS OF JAPAN vol. 016, no. 559 (P-1455), 30. November 1992 (1992-11-30) -& JP 04 213401 A (NIPPON SHEET GLASS CO LTD), 4. August 1992 (1992-08-04)

## Beschreibung

Die vorliegenden Erfindung betrifft ein passives optisches Mehrfachbauteil zur Verwendung mit Leuchtdioden.

Es ist bekannt, auf Leiterplatten montierte Arrays von Lichtemissionsdioden (Light Emitting Diode, LED) für Beleuchtungszwecke anzuwenden. Beispielsweise bei Lichtwerbung, wie Buchstabenhinterleuchtung, Kunststoffhinterleuchtung et cetera, bei Sicherheitsbeleuchtungen, wie Rettungswege-Beleuchtung, Orientierungsbeleuchtung, Markierungsbeleuchtungen, sowie bei Beleuchtungen für Kraftfahrzeuge ist es bekannt, anstelle konventioneller Glühlampen oder Gasentladungslampen LEDs zu verwenden, welche eine längere Lebensdauer, einen besseren Wirkungsgrad bei der Umwandlung elektrischer Energie in Strahlungsenergie im sichtbaren Spektralbereich, damit verbunden eine geringere Abgabe von Verlustleistung sowie einen geringeren Platzbedarf aufweisen. Insbesondere bei der Lichtwerbung kommt der hohen Flexibilität bezüglich geometrischer Formgebung und Farbenvielfalt, welche LEDs bieten, eine große Bedeutung zu.

In dem Gebrauchsmuster DE 298 18 609 U1 ist eine Anordnung von Platinen zur beliebigen Erstellung von Leuchtdioden-Beleuchtungseinheiten angegeben, bei der eine Vielzahl von flächig zusammenhängenden, leuchtdiodentragenden Platinen vorgesehen ist, welche vieleckig ausgebildet und untereinander durch Stege verbunden sind. Aus dieser matrixförmigen Anordnung von Platinen kann eine beliebige Anzahl beziehungsweise Teilmenge der leuchtdiodentragenden Platinen herausgebrochen werden, so daß sich Teilmengen mit vielfältigen Gestaltungsmöglichkeiten bezüglich der geometrischen Abmessungen ergeben.

In den Druckschriften WO 99/41785 A1 und CH 689 339 A5 ist ein konfektionierbares LED-Leuchtpaneel angegeben. Dieses umfaßt eine Vielzahl von LED-Chips, auf denen jeweils eine optisch transparente Schutzschicht aufgebracht ist. Das Leuchtpaneel ist in Untereinheiten zerteilbar.

Die Druckschrift JP 04-213401 A offenbart eine Methode zum Schneiden eines optischen Elements, in dem durch Ionendiffusion in einer Salzschmelze Mikrolinsen-Arrays erzeugt sind.

Die Druckschrift DE 93 07 862 U betrifft einen Leuchtkörper für Leuchtreklamen.

In der Druckschrift US 5,660,461 A ist ein Array optoelektronischer Bauteile sowie eine Herstellungsmethode hierfür angegeben.

Die Druckschrift DE 2 255 923 U offenbart ein Verfahren zum Abformen von optischen Linsen aus organischem Material sowie nach diesem Verfahren hergestellte Linsen.

Eine Mehrfach-Leuchtdiodenanordnung ist in der Druckschrift DE 31 48 843 A1 beschrieben.

Leuchtdioden haben normalerweise eine im wesentlichen punktförmige Lichtquelle, welche beispielsweise eine kegelförmige Abstrahlung mit einem Öffnungswinkel von 120° aufweist.

Aufgabe der vorliegenden Erfindung ist es, eine Optik anzugeben, welche in einfacher Weise in einem Massenherstellungsverfahren erzeugbar ist und welche eine flexible Anpassung an geometrische Vorgaben ermöglicht.

Erfindungsgemäß wird die Aufgabe mit einem passiven optischen Mehrfachbauteil zur Verwendung mit Leuchtdioden gelöst, aufweisend mehrere passive strahlformende und/oder strahlumformende Einzelbauelemente,
- welche strahlungsdurchlässig sind, und
- welche miteinander zur Bildung des passiven Strahloptik-Moduls über Verbindungsmittel verbunden sind, die als Sollbruchstellen ausgebildet sind. Ferner ist das Mehrfachbauteil einstückig und spritzgegossen. Weiterhin sind die Sollbruchstellen entlang einer geschlossenen Linie dem Umfang der Einzelbauelemente entlang ausgebildet. Über die Sollbruchstellen ist das Mehrfachbauteil in optische Bauteile zerteilbar, die ein oder mehrere Einzelbauelemente umfassen.

Unter einem strahloptischen Einzelbauelement ist ein strahlformendes und/oder strahlumlenkendes optisches Bauteil verstanden, wie beispielsweise Sammellinsen, Streulinsen oder Prismen.

Das passive optisches Mehrfachbauteil, im folgenden auch als Strahloptik-Modul bezeichnet, ist also einstückig gefertigt.

Das passive Strahloptik-Modul ist als vollständig passives optisches Bauteil ausgebildet.

Der Erfindung liegt das Prinzip zugrunde, ein modular aufgebautes optisches Mehrfachbauteil anzugeben, welches eine Vielzahl von fest miteinander verbundenen optischen Einzelbauelementen aufweist, wobei das optische Mehrfachbauteil in optische Bauteile zerteilbar ist, welche mehrere optische Einzelbauelemente umfassen können. Hierdurch ist eine große Flexibilität bei der Formgebung der optischen Bauteile, welche mit dem optischen Mehrfachbauteil herstellbar sind, gegeben, da eine Anpassung an geometrische Formvorgaben in einfacher Weise möglich ist.

Zwischen den Einzelbauelementen sind Sollbruchstellen vorgesehen. Die Sollbruchstellen sind dabei entlang einer geschlossenen Linie dem Umfang der Einzelbauelemente entlang vorgesehen. Hierdurch kann vom Anwender ohne Werkzeug, beispielsweise entlang einer Kante, das optische Mehrfachbauteil in optische Bauteile zerteilt werden, die ein oder mehrere optische Einzelbauelemente umfassen.

Obwohl das optische Mehrfachbauteil in einem Massenherstellungsverfahren erzeugbar ist, können Anwendungen für Einzelstücke oder Kleinserien ermöglicht werden, die sonst eine spezielle Entwicklung, beispielsweise eine Herstellung von speziellen Spritzguß-Formen, erfordern würden.

Besonders vorteilhaft ist das optische Mehrfachbauteil in Verbindung mit einer Mehrfachanordnung von mit LEDs bestückten Leiterplatten, welche ebenfalls in Untermengen von fest miteinander verbundenen Leiterplatten mit einer beliebig wählbaren Anzahl von Leuchtdioden und einer nahezu beliebigen Formgebung ermöglichen.

Die geometrische Formgebung der Einzelbauelemente, insbesondere der Sollbruchstellen, kann dabei an die Formgebung der einzelnen, die Mehrfachanordnung bildenden Leiterplatten mit LEDs angepaßt sein.

Eine mit vorliegendem Prinzip geschaffene, modulare Aufbauweise ermöglicht eine hohe Flexibilität in der Anwendung, da beliebig vereinzelbare optische Bauteile verschiedener Eigenschaften wie Farbe, Material, Lichtbündelung oder -streuung etc. beliebig kombinierbar sind mit ebenfalls beliebig zerteilbaren LED-Mehrfachbauteilen. Dabei können mehrere optische Bauteile unterschiedlicher Eigenschaften, beispielsweise mit unterschiedlichen Lichtaustrittswinkeln mit Vorteil mit beispielsweise einem LED-Mehrfachbauteil kombiniert werden, beispielsweise durch Zusammenstecken.

Das optische Mehrfachbauteil ist in einfacher weise in einem Spritzguß-Verfahren hergestellt. Bei Anwendungen, welche große zu beleuchtende oder hinterleuchtende Flächen haben, können mehrere optische Mehrfachbauteile aneinandergefügt werden.

In einer vorteilhaften Ausführungsform der vorliegenden Erfindung weist das optische Mehrfachbauteil in einer zweidimensionalen Matrixstruktur angeordnete optische Einzelbauelemente auf. Ein derartiges optisches Mehrfachbauteil ist besonders einfach herstellbar und flexibel anwendbar.

In einer weiteren, vorteilhaften Ausführungsform der vorliegenden Erfindung weisen die Einzelbauelemente eine quadratische Grundfläche auf. Dabei stellt jedes Einzelbauelement eine Zelle der Matrixstruktur, welche in Spalten und Zeilen gegliedert ist, dar.

In einer weiteren, vorteilhaften Ausführungsform der vorliegenden Erfindung sind zur Bildung der Sollbruchstellen Gebiete mit verringerter Materialstärke vorgesehen. Wenn die Sollbruchstellen durch Gebiete mit verringerter Materialstärke gebildet sind, so kann das optische Mehrfachbauteil eine glatte, ununterbrochene Oberfläche haben, welche einfach zu reinigen ist. Zudem sind Spritzguß-Formen, welche Gebiete mit verringerter Materialstärke haben, in einfacher Weise und mit geringem Aufwand herstellbar.

In einer weiteren Ausführungsform der vorliegenden Erfindung weist das optische Mehrfachbauteil eine glatte Oberfläche auf. Hierdurch kann auch bei optischen Bauteilen, die mehrere optische Einzelbauelemente umfassen, und bei denen jedem optischen Einzelbauelement jeweils eine Leuchtdiode zugeordnet ist, eine homogene Leuchtdichte ohne sichtbaren Übergang zwischen den optischen Einzelbauelementen erreicht werden. Diese homogene Leuchtdichte beziehungsweise gleichmäßige Helligkeitsverteilung ist dabei unabhängig von der Größe und der geometrischen Formgebung der gewünschten Anwendung und damit des optischen Bauteils.

In einer weiteren, vorteilhaften Ausführungsform der vorliegenden Erfindung weisen die Einzeloptiken jeweils Mittel zur Erzeugung einer homogenen Leuchtdichte an einer für den Betrachter sichtbaren Oberfläche bei einfallender Lichtstrahlung auf. Hierdurch sind beispielsweise gleichmäßig hell beleuchtete Firmenlogos, Leuchtschriften et cetera realisierbar.

In einer weiteren, vorteilhaften Ausführungsform der vorliegenden Erfindung besteht das optische Mehrfachbauteil vollständig aus dem Material PMMA (Polymethylmetacrylat).

PMMA ist weit verbreitet, ermöglicht eine einfache Handhabung bei der Herstellung, hat ausgezeichnete optische Eigenschaften und ist in einfacher Weise einfärbbar, was besonders bei Lichtwerbung und Sicherheitsbeleuchtung, beispielsweise Rettungswege-Beleuchtung, von Bedeutung ist. Alternativ kann das Mehrfachbauteil vollständig aus dem Material Polycarbonat hergestellt sein.

In einer weiteren, vorteilhaften Ausführungsform der vorliegenden Erfindung weisen die optischen Einzelbauelemente untereinander gleiche geometrische Form auf. Hierdurch ist ein hoher Modularitätsgrad sowie eine einfache Formherstellung für ein Spritzgußverfahren sowie eine gute Homogenität der Lichtverteilung möglich.

Die optischen Einzelbauelemente und damit das optische Mehrfachbauteil können je nach Anwendungsfall streuende oder bündelnde Optiken aufweisen.

Das vorliegende Prinzip vermeidet das Erfordernis des Entwikkelns spezieller LED-Optiken und deren Herstellung für Einzelanwendungen, beispielsweise Firmenlogos, Leuchtreklamen et cetera.

Weitere Einzelheiten der vorliegenden Erfindung sind in den Unteransprüchen angegeben.

Die Erfindung wird nachfolgend an einem Ausführungsbeispiel anhand der Zeichnungen näher erläutert. Es zeigen:
- Figur 1a: ein optisches Mehrfachbauteil mit quadratischen Einzelbauelementen in einer Draufsicht,
- Figur 1b: das optische Mehrfachbauteil aus Figur 1a in einer Seitenansicht,
- Figur 2: das optische Mehrfachbauteil gemäß Figur 1a, bei dem ein mehrere optische Einzelbauelemente umfassendes optisches Bauteil herausgetrennt ist,
- Figur 3a: eine Mehrfachanordnung von mit LEDs bestückten Leiterplatten in einer Draufsicht,
- Figur 3b: die Mehrfachanordnung von Figur 3a in einer Seitenansicht,
- Figur 4a: die Mehrfachanordnung von Figur 3a mit einem optischen Bauteil gemäß Figur 2 in einer Draufsicht, und
- Figur 4b: die Mehrfachanordnung mit optischem Bauteil gemäß Figur 4a in einer Seitenansicht.

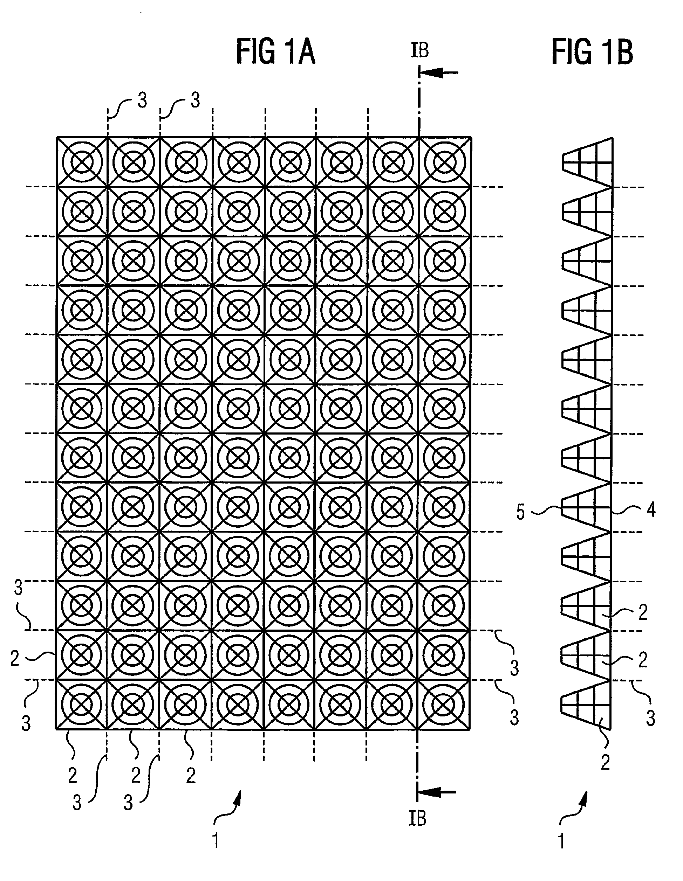

Figur 1a zeigt ein optisches Mehrfachbauteil 1 mit einer Vielzahl von in einer matrixförmigen Struktur angeordneten, optischen Einzelbauelementen 2 mit quadratischer Grundfläche. Zwischen den optischen Einzelbauelementen 2 sind entlang der Kanten der optischen Einzelbauelemente 2 Sollbruchstellen 3 vorgesehen. Die Sollbruchstellen 3 sind dabei in zwei zueinander orthogonalen Richtungen angeordnet. Die Sollbruchstellen 3 sind derart realisiert, daß entlang der Sollbruchstellen 3 die Materialstärke des optischen Mehrfachbauteils 1 so gering ist, daß ein einfaches, maschinelles oder manuelles Auseinanderteilen des optischen Mehrfachbauteils 1 in ein oder mehrere optische Einzelbauelemente 2 umfassende optische Bauteile möglich ist. Beispielsweise kann das Zerteilen des optischen Mehrfachbauteils 1 in ein oder mehrere optische Einzelbauelemente 2 umfassende optische Bauteile ohne Werkzeug manuell entlang einer Brechkante erfolgen.

Jedes optische Einzelbauelement 2 weist eine Optik auf, welche jeweils einer Leuchtdiode oder Laserdiode zugeordnet ist. Die Optik eines optischen Einzelbauelements 2 wandelt einfallendes Licht, welches von einer punktförmigen Leuchtdiode kegelförmig ausgestrahlt wird, in einen parallelen Strahlengang bei homogener Leuchtdichte. Hierfür kann beispielsweise eine Fresnel-Optik vorgesehen sein.

Die Anordnung gemäß Figur 1a weist den Vorteil auf, daß das optische Mehrfachbauteil in einfacher Weise in einem Massenherstellungsverfahren durch Spritzguß herstellbar ist. Aufgrund des matrixförmigen Aufbaus des optischen Mehrfachbauteils mit einer Vielzahl von in einem Array angeordneten optischen Einzelbauelementen 2, welche sich untereinander in ihren geometrischen Abmessungen gleichen, ist eine einfache, flexible Anpassung der Größe der gewünschten optischen Anordnung und somit des optischen Bauteils bei beliebiger Anzahl zusammenhängender optischer Einzelbauelemente möglich. Die Sollbruchstellen 3 mit verringerter Materialstärke des PMMA (Polymethylmetacrylat)-Materials gestatten aufgrund der erzielbaren, homogenen Leuchtdichte über mehrere optische Einzelbauelemente hinweg gemeinsam mit entsprechend gestalteten Leuchtdioden die Realisierung von Sicherheitsbeleuchtungseinrichtungen, Effektbeleuchtungen und Lichtwerbung.

Abweichend von der Realisierung gemäß Figur 1a kann je nach Anwendungsfall die Optik der optischen Einzelbauelemente streuend oder bündelnd realisiert sein. Falls die Anzahl der optischen Einzelbauelemente in einem optischen Mehrfachbauteil oder die Abmessungen des optischen Mehrfachbauteils für den Anwendungsfall nicht ausreichen, können mehrere optische Mehrfachbauteile (Nutzen) beispielsweise durch Kleben aneinandergefügt werden, um eine beliebig große Fläche zu erzielen.

Figur 1b zeigt einen Querschnitt durch das optische Mehrfachbauteil 1 von Figur 1a. Deutlich sind dabei die Sollbruchstellen 3 zwischen den optischen Einzelbauelementen 2 mit einer geringen Materialstärke erkennbar. Die Vorderseite 4 des optischen Mehrfachbauteils beziehungsweise der optischen Einzelbauelemente 2 weist eine glatte Oberfläche auf, so daß Verschmutzungen beispielsweise bei Anwendung im Außenbereich gering bleiben und eine Reinigung in einfacher Weise möglich ist. Die Rückseite 5 jedes optischen Einzelbauelements 2 weist eine Stecköffnung für ein Leuchtmittel, beispielsweise für eine Leuchtdiode oder eine Laserdiode, auf.

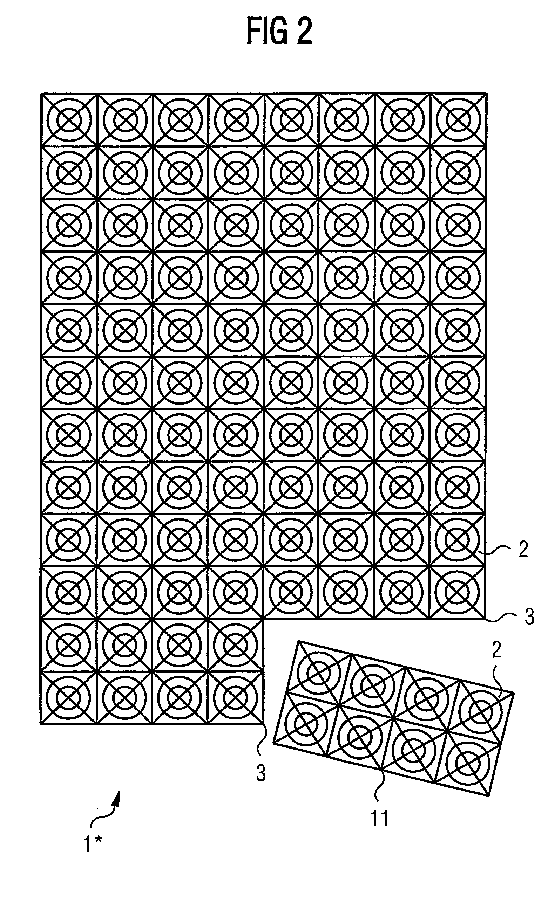

Figur 2 zeigt ein optisches Mehrfachbauteil 1, bei dem ein acht optische Einzelbauelemente 2 umfassendes optisches Bauteil 11 entlang von Sollbruchstellen 3 zwischen den optischen Einzelbauelementen 2 herausgetrennt ist. Selbstverständlich können sowohl das verbleibende optische Mehrfachbauteil 1* als auch das optische Bauteil 11 entlang von weiteren Sollbruchstellen 3 unter Bildung weiterer optischer Einzelbauelemente zerteilt werden.

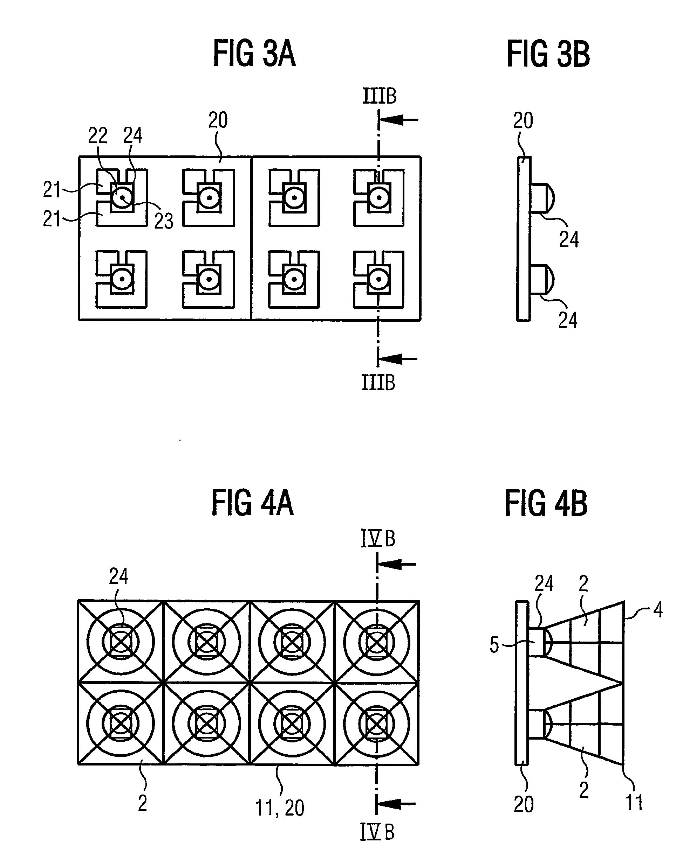

Figur 3a zeigt eine Mehrfachanordnung 20 von mit LEDs bestückten Leiterplatten, wobei die Mehrfachanordnung 20 mehrere LED-Chips 24 aufweist, welche mit großflächigen Kontakten 21 auf der Leiterplatte 20 angeordnet sind. Der LED-Chip 24 weist jeweils die eigentliche LED-Lichtquelle 23 sowie einen Reflektor 22 auf. Auch hier ist eine modulare Struktur der Leuchtdioden gegeben, so daß ebenfalls beliebige Anzahlen von Leuchtdioden, welche untereinander fest zusammenhängend sind, erzeugbar sind.

Figur 3b zeigt einen Querschnitt durch die Mehrfachanordnung von mit LEDs bestückten Leiterplatten 20 mit LED-Chips 24 gemäß Figur 3a. Letztere sind so ausgeformt, daß gemeinsam mit der eine Stecköffnung aufweisenden Rückseite 5 der optischen Einzelbauelemente 2 eine Steckverbindung herstellbar ist.

Figur 4a zeigt das optische Bauteil 11 von Figur 2, aufgesteckt auf die Mehrfachanordnung von mit LEDs bestückten Leiterplatten 20. Dabei ist zu erkennen, daß die Mittelpunkte der optischen Einzelbauelemente 2 des optischen Bauteils 11 jeweils so angeordnet sind, daß sie mit den LED-Lichtquellen 23 übereinstimmen. Somit ist jeweils ein optisches Einzelbauelement 2 einem LED-Chip 24 zugeordnet.

Figur 4b zeigt einen Querschnitt durch die Verbindung von optischem Bauteil 11 und Mehrfachanordnung von mit LEDs bestückten Leiterplatten 20 gemäß Figur 4a. Die optischen Einzelbauelemente 2 sind mit ihrer Rückseite 5 jeweils auf den LED-Chip 24 der Mehrfachanordnung von mit LEDs bestückten Leiterplatten 20 aufgesteckt. Man erkennt, daß die optischen Einzelbauelemente 2 und insgesamt das optische Bauteil 11 eine ebene, glatte Oberfläche aufweist.

Neben der beschriebenen quadratischen Form der optischen Einzelbauelemente 2 können diese auch andere Formen, wie Wabenform, Dreieckform, Rechteckform etc. aufweisen.

## Patentansprüche

1. Passives optisches Mehrfachbauteil (1) zur Verwendung mit Leuchtdioden (23), das mehrere passive strahlformende und/oder strahlumlenkende Einzelbauelemente (2), welche strahlungsdurchlässig sind, aufweist,
wobei das optische Mehrfachbauteil einstückig und spritzgegossen ist und zwischen den passiven strahlformenden und/oder strahlumlenkenden Einzelbauelementen (2) Sollbruchstellen (3) aufweist, mittels derer es in optische Bauteile, die ein oder mehrere Einzelbauelemente (2) umfassen, zerteilbar ist,
und wobei die Sollbruchstellen (3) entlang einer geschlossenen Linie dem Umfang der Einzelbauelemente (2) entlang ausgebildet sind.

2. Mehrfachbauteil (1) nach Anspruch 1,
**dadurch gekennzeichnet, daß**
das passive Strahloptik-Modul (1) in einer zweidimensionalen Matrixstruktur angeordnete passive strahlformende und/oder strahlumlenkende Einzelbauelemente (2) aufweist.

3. Mehrfachbauteil (1) nach Anspruch 2,
**dadurch gekennzeichnet, daß**
die Einzelbauelemente (2) eine quadratische Grundfläche aufweisen und jeweils eine durch Zeilen und Spalten der Matrixstruktur bestimmte Zelle der Matrixstruktur realisieren.

4. Mehrfachbauteil (1) nach einem der Ansprüche 1 bis 3,
**dadurch gekennzeichnet, daß**
zur Bildung der Sollbruchstellen (3) Gebiete mit verringerter Materialstärke vorgesehen sind.

5. Mehrfachbauteil (1) nach einem der Ansprüche 1 bis 4,
**dadurch gekennzeichnet, daß**
das Mehrfachbauteil (1) eine glatte Oberfläche (4) aufweist.

6. Mehrfachbauteil (1) nach Anspruch 5,
**dadurch gekennzeichnet, daß**
die Einzelbauelemente (2) Optiken aufweisen, die Mittel zur Erzeugung einer homogenen Leuchtdichte an der Oberfläche (4) bei einfallender Strahlung aufweisen.

7. Mehrfachbauteil (1) nach einem der Ansprüche 1 bis 6,
**dadurch gekennzeichnet, daß**
das Mehrfachbauteil (1) aus dem Material PMMA besteht.

8. Mehrfachbauteil (1) nach einem der Ansprüche 1 bis 7,
**dadurch gekennzeichnet, daß**
die Einzeloptiken (2) untereinander eine gleiche geometrische Form aufweisen.

9. Mehrfachbauteil (1) nach einem der Ansprüche 1 bis 8,
**dadurch gekennzeichnet, daß**
das optische Einzelbauelement (2) an dessen Rückseite (5) eine Stecköffnung zur Aufnahme von Leuchtdioden (23) aufweist.

## Claims

1. Passive optical multiple device (1) for use with light-emitting diodes (23), which has a plurality of passive beam-shaping and/or beam-deflecting individual components (2) which are radiation-transmissive,
wherein the optical multiple device is integral and injection-moulded and has, between the passive beam-shaping and/or beam-deflecting individual components (2), predetermined breaking locations (3) by means of which it can be divided into optical devices comprising one or a plurality of individual components (2),
and wherein the predetermined breaking locations (3) are formed along a closed line along the periphery of the individual components (2).

2. Multiple device (1) according to Claim 1,
**characterized in that**
the passive optical multiple device (1) has passive beam-shaping and/or beam-deflecting individual components (2) arranged in a two-dimensional matrix structure.

3. Multiple device (1) according to Claim 2,
**characterized in that**
the individual components (2) have a square base area and in each case realize a cell of the matrix structure that is determined by rows and columns of the matrix structure.

4. Multiple device (1) according to any of Claims 1 to 3,
**characterized in that**
regions having a reduced material thickness are provided for forming the predetermined breaking locations (3).

5. Multiple device (1) according to any of Claims 1 to 4,
**characterized in that**
the multiple device (1) has a smooth surface (4).

6. Multiple device (1) according to Claim 5,
**characterised in that**
the individual components (2) have optical systems having means for producing a homogeneous luminance at the surface (4) in the case of incident radiation.

7. Multiple device (1) according to any of Claims 1 to 6,
**characterized in that**
the multiple device (1) consists of the material PMMA.

8. Multiple device (1) according to any of Claims 1 to 7,
**characterized in that**
the optical individual components (2) have an identical geometrical form among one another.

9. Multiple device (1) according to any of Claims 1 to 8,
**characterized in that**
the optical individual component (2) has, at its rear side (5), a plug-in opening for receiving light-emitting diodes (23).

## Revendications

1. Composant optique passif multiple (1) destiné à être utilisé avec des diodes électroluminescentes (23),
lequel présente plusieurs composants passifs individuels (2) de formage de rayon et/ou de déviation de rayon, lesquels laissent passer le rayonnement, le composant optique multiple étant d'une seule pièce et moulé par injection et présentant entre les composants passifs individuels (2) de formage de rayon et/ou de déviation de rayon des points de rupture voulus (3) au moyen desquels il peut être divisé en composants optiques qui comprennent un ou plusieurs composants individuels (2), et les points de rupture voulus (3) étant formés le long d'une ligne fermée le long du pourtour des composants individuels (2).

2. Composant multiple (1) selon la revendication 1, **caractérisé en ce que** le composant optique passif multiple (1) présente des composants passifs individuels (2) de formage de rayon et/ou de déviation de rayon disposés dans une structure matricielle bidimensionnelle.

3. Composant multiple (1) selon la revendication 2, **caractérisé en ce que** les composants individuels (2) présentent une surface de base carrée et réalisent à chaque fois une cellule de la structure matricielle définie par des lignes et des colonnes de la structure matricielle.

4. Composant multiple (1) selon l'une des revendications 1 à 3, **caractérisé en ce que** des zones ayant une épaisseur de matériau plus faible sont prévues pour former les points de rupture voulus (3).

5. Composant multiple (1) selon l'une des revendications 1 à 4, **caractérisé en ce que** le composant multiple (1) présente une surface (4) lisse.

6. Composant multiple (1) selon la revendication 5, **caractérisé en ce que** les composants individuels (2) présentent des optiques qui présentent des moyens pour générer une densité lumineuse homogène sur la surface (4) en présence d'un rayonnement incident.

7. Composant multiple (1) selon l'une des revendications 1 à 6, **caractérisé en ce que** le composant multiple (1) est constitué de matériau PMMA.

8. Composant multiple (1) selon l'une des revendications 1 à 7, **caractérisé en ce que** les optiques individuelles (2) présentent entre elles une même forme géométrique.

9. Composant multiple (1) selon l'une des revendications 1 à 8, **caractérisé en ce que** le composant optique individuel (2) présente sur son côté arrière (5) une ouverture d'enfichage pour recevoir des diodes électroluminescentes (23).
